Europäisches Patentamt

European Patent Office

Office européen des brevets

(19)

(11) Veröffentlichungsnummer: **0 056 972**
**B1**

# (12) EUROPÄISCHE PATENTSCHRIFT

(45) Veröffentlichungstag der Patentschrift:
02.09.87

(21) Anmeldenummer: **82100337.3**

(22) Anmeldetag: **19.01.82**

(51) Int. Cl.⁴: **H 01 L 21/268**

(54) **Verfahren und Vorrichtung zur Herstellung von Halbleiterelementen mit bestimmten physikalischen Parametern.**

(30) Priorität: **24.01.81 DE 3102337**

(43) Veröffentlichungstag der Anmeldung:
**04.08.82 Patentblatt 82/31**

(45) Bekanntmachung des Hinweises auf die Patenterteilung:
**02.09.87 Patentblatt 87/36**

(84) Benannte Vertragsstaaten:
**AT BE CH DE FR GB IT LI NL SE**

(56) Entgegenhaltungen:
**DE-A-2 837 315**
**US-A-4 021 898**
**US-A-4 182 024**

**SIEMENS-ZEITSCHRIFT, Band 41, Heft 4, 1967, München, DE., G. RAUSCHER: "UBL 5001, ein Universal-Bearbeitungs-Laser", Seiten 273-275**

(73) Patentinhaber: **Schaumburg, Hanno, Prof. Dr.- Ing., Dörpsweg 47, D-2000 Hamburg 54 (DE)**

(72) Erfinder: **Schaumburg, Hanno, Prof. Dr.- Ing., Dörpsweg 47, D-2000 Hamburg 54 (DE)**

(74) Vertreter: **Dickel, Klaus, Dipl.- Ing., Julius- Kreis- Strasse 33, D-8000 München 60 (DE)**

## Beschreibung

Die Erfindung betrifft ein Verfahren und eine Vorrichtung zur Herstellung von Halbleiterbauelementen, bei dem das dotierte Halbleiterbauelement mit einer seine Eigenschaften verändernden optischen Strahlung bestrahlt, der zwischen zwei am Halbleiterbauelement angreifenden Meßspitzen auftretende Widerstand innerhalb des Halbleiterbauelements gemessen und das Meßergebnis zur Steuerung der Bestrahlungsintensität und -dauer benutzt wird.

Ein derartiges Verfahren sowie die entsprechende Vorrichtung werden bereits in der DE-A-2 837 749 beschrieben. Auf diese Weise lassen sich Veränderungen der Schichtwiderstände von Halbleiterbauelementen gezielt vornehmen.

Es ist andererseits auch bekannt, daß sich der Schicht widerstand und weitere physikalische Eigenschaften, wie z. B. der Temperatur- und der piezoresistive Koeffizient, in Halbleitern allgemein, besonders aber in polykristallinen Schichten von Halbleitern ändern, wenn diese mit intensiver optischer Strahlung, z. B. Laserstrahlung, behandelt werden. Die physikalische Ursache hierfür ist, daß sich unter Einfluß einer solchen Strahlung das Gefüge in einer polykristallinen Schicht ändert, d.h., die Kristallkörner vergrößern sich, die Dichte der mit Korngrößen und anderen Gitterfehlern verbundenen elektrischen Störstellen und Parameter, wie die elektrische Ladungsträgerdichte und die Ladungsträgerlebensdauer, sowie die Beweglichkeit ändern sich. Alle diese Strukturveränderungen sowie weitere, hier nicht erwähnte Erscheinungen führen zu einer Veränderung der oben erwähnten physikalischen Eigenschaften der Bauelemente.

Nun ist jedoch mit dem eingangs genannen Verfahren die quantitative Einstellung derartiger physikalischer Eigenschaften von Halbleiterelementen nicht oder nur mit einer großen Toleranz oder Bandbreite möglich.

Der Erfindung liegt dementsprechend die Aufgabe zugrunde, das Verfahren der eingangs genannten Art sowie eine entsprechende Vorrichtung derart auszugestalten, daß sich eine hohe quantitative Einstellgenauigkeit einer physikalischen Eigenschaft, die durch den funktionellen Zusammenhang zwischen dem Widerstand und einer ihn beeinflußenden Einflußgröße definierbar ist, und damit eine gleichbleibend hohe Qualität der hergestellten Halbleiterbauelemente erzielen läßt.

Gelöst wird diese Aufgabe gemäß der Erfindung dadurch, daß man bei dem eingangs genannten Verfahren zur Einstellung einer vorgegebenen quantitativen Abhängigkeit des Widerstandes von einer ihn beeinflußenden physikalischen Einflußgröße das Halbleiterbauelement mit den Meßspitzen in eine Einrichtung zur reproduzierbaren Einstellung vorbestimmter Werte der betreffenden Einflußgröße eingesetzt wird, zwei unterschiedliche feste Werte der Einflußgröße eingestellt und die zwei zugehörigen Widerstandswerte gemessen werden, und daß das Halbleiterbauelement solange wiederholt mit einer entsprechenden Intensität der optischen Strahlung bestrahlt wird, bis sich bei dem Bauelement für die zwei festen Werte der Einflußgröße zugehörige Widerstandswerte eingestellt haben, deren Differenz einen vorgegebenen Wert aufweist.

Die erfindungsgemäße Vorrichtung umfaßt eine erste Strahlungsquelle für die optische Strahlung, eine Einstelleinrichtung für die Strahlungsintensität, eine optische Einstelleinrichtung für die dem Halbleiterbauelement zugeführte Strahlung sowie am Halbleiterbauelement angreifende Meßspitzen, die mit einer elektrischen Steuerung für die Einstelleinrichtung für die Strahlungsintensität in Verbindung stehen, wobei nach der Erfindung im Bereich des Bauelementes eine Einrichtung zur Einstellung vorbestimmter Werte einer Einflußgröße angeordnet ist, die den zwischen den Meßspitzen innerhalb des Halbleiterbauelements auftretenden Widerstand beeinflußt. Die Einrichtung ist gemäß verschiedenen Ausführungsformen so ausgebildet, daß sich das Bauelement auf eine bestimmte Temperatur, Lichtbestrahlung, oder elastische Vorspannung einstellen läßt.

Durch die erfindungsgemäße Einbettung des Bauelementes in die geannte Einrichtung ist es möglich, die auf das Halbleiterbauelement einwirkende Einflußgröße an dem Bauelement gezielt und systematisch zu ändern. Entsprechen z. B. die Zustände $G_0$ und $G_1$ zwei unterschiedlichen Werten der Einflußgröße, dann entsprechen diesen die Widerstandswerte $R_0$ und $R_1$ des Bauelementes. Zur Steuerung der Intensität 1 wird dann nicht nur der Absolutwert von $R_0$ und $R_1$, sondern insbesondere deren Differenz $R_0 - R_1$ herangezogen.

Durch das erfindungsgemäße Verfahren mit der entsprechenden Vorrichtung ist es erstmals möglich, physikalische Eingeschaften, die bislang nur mit großer Schwenkungsbreite, d. h., mit großen Fertigungstoleranzen, reproduziert werden konnten, sehr gezielt zu beherrschen. Als besonderes Anwendungsgebiet kommt hierfür die Herstellung eng tolerierter Sensoren für die Messung von Temperatur, Druck, Lichteinstrahlung usw. in Frage, wie auch etwa die Herstellung von Widerständen in integrierten Schaltungen mit vorgegebenen Eigenschaften.

Die Einstellgenauigkeit bei diesem Verfahren hängt nur von der Reproduzierbarkeit ab, mit welcher sich die physikalischen Eingeschaft von der Bestrahlung beeinflussen läßt und der kostenmäßig vertretbaren Bestrahlungszeit. Es lassen sich mit diesem Verfahren physikalische Eingeschaften, die gewöhnlich nur schwer beherrschbar sind, in Toleranzgrenzen von weniger als 1 % quantitativ einstellen.

Weitere Vorteile, Einzelheiten und erfindungswesentliche Merkmale ergeben sich aus der nachfolgenden Beschreibung verschiedener Ausführungsbeispiele der Erfindung unter Bezugnahme auf die beigefügten Zeichnungen. Dabei zeigt im einzelnen:

Fig. 1 eine schematische Darstellung der Vorrichtung zur Durchführung des erfindungsgemäßen Verfahrens in allgemeiner form,

Fig. 2 eine bevorzugte Ausführungsform der Vorrichtung gemäß Fig. 1, etwa zur Einstellung des Temperaturkoeffizienten oder der Photoempfindlichkeit in schematischer Darstellung,

Fig 3 die Vorrichtung zur Einstellung des piezoresistiven Koeffizienten, wobei die Erichtung zur Erzeugung der elastischen Vorspannung schematisch dargestellt ist,

Fig. 4 eine der fig. 3 entsptechende andere Ausführungsform der Erfindung.

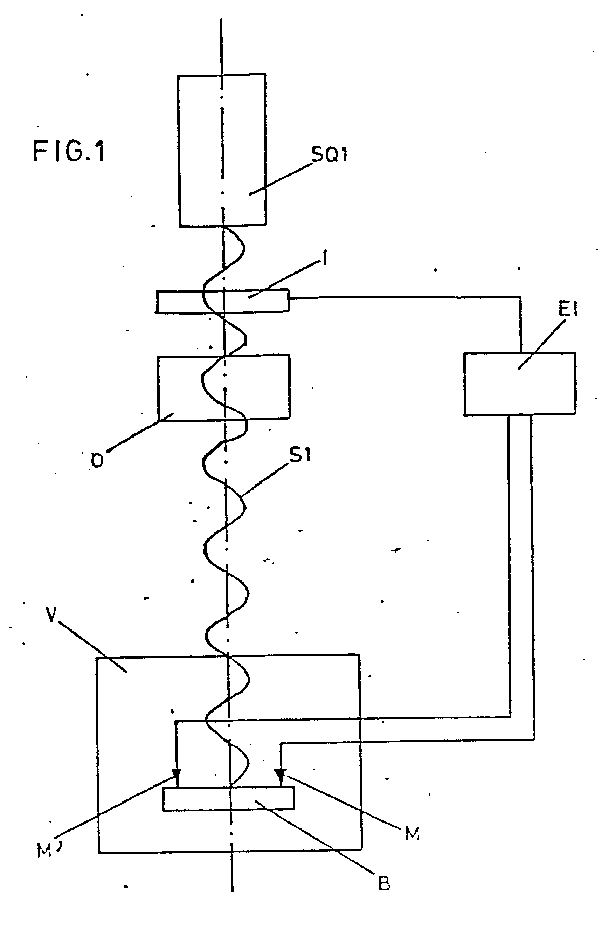

Das Verfahren soll zunächst allgemein anhand von Fig. 1 erläutert werden. Der Schichtwiderstand des Bauelementes B wird verändert, indem dieses einer hierauf gerichteten, intensiven Bestrahlung S1 ausgesetzt wird. Die Strahlung, bei der es sich um eine Laserstrahlung handeln kann, wird durch die Strahlungsquelle SQ1, z. B. eine Laserkanone, erzeugt. Die Strahlung S1 durchläuft eine Einrichtung I zur Intensitätseinstellung des Strahles. Weiterhin ist innerhalb des Strahlenganges eine optische Einstelleinrichtung O zur Erzeugung eines vorbestimmten Musters angeordnet.

An einer Testfigur des Bauelementes angreifende Meßspitzen M,M' nehmen die Veränderung auf und führen sie einer Steuerungseinrichtung E1 zu, über welche die Intensität des Strahles S1 eingestellt werden kann.

Das Bauelement B ist zusammen mit den Meßspitzen M,M' in eine Einrichtung V eingebettet, in welcher sich vorbestimmte Werte die den Widerstand im Halbleiter bauelement beeinflußenden Einflußgröße einstellen lassen.

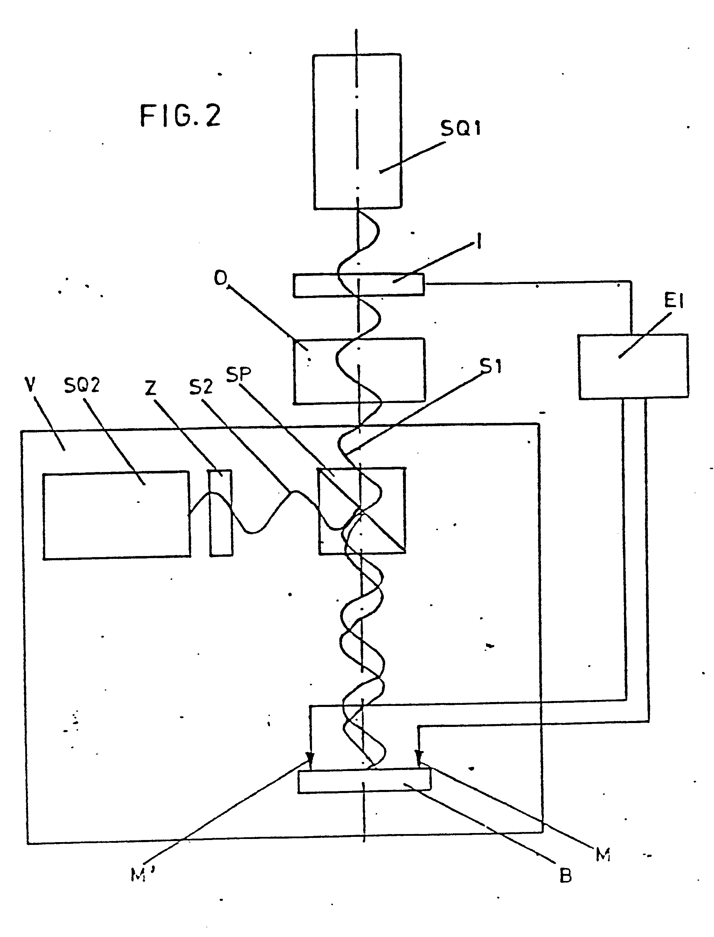

Mit der in Fig. 2 schematisch dargestellten Vorrichtung V läßt sich die Veränderung der Temperatur des Bauelementes B steuern. Einer zweiten Strahlungsquelle SQ2 ist ein Zeitschalter Z vorgeschaltet, der die Zeitdauer der Strahlung S2 zu steuern vermag. Die Strahlung S2 wird über ein Spiegelsystem SP auf das Bauelement B gerichtet, wobei sich die Strahlungen S1 und S2 überlagern können. Die Anordnung ist so ausgebildet, daß wahlweise die Strahlungen S1, S2 oder S1 + S2 dem Bauelement B zugefühtt werden können.

Untetwirft man nun das Bauelement B füt eine bestimmte Zeitspanne der Strahlung S2, so wird dort eine Temperaturerhöhung auf T1, ausgehend von einer Ausgangstempetatur T0 vetutsacht. Diesen Temperaturen entsprechen die Werte $R_{T0}$ und $R_{T1}$ des am Halbleiterbauelementes $B_4$ gemessenen Widerstandes. Aus der Differenz $R_{T0}$ - $R_{T1}$ wird ein Steuersignal für die Intensität der Strahlungsquelle S01 hergeleitet, d. h., das Halbleiterbauelement wird so lange mit einer entsprechenden Intensität von SQ1 bestrahlt, bis sich auf dem Bauelement ein vorgegebener Wert von $R_{T0}$ - $R_{T1}$ eingestellt hat. Gleiche Temperaturen T0 und T1 füt wiederholte Beaufschlagung mit der Strahlungsquelle SQ1 werden durch eine gesteuerte Aufheizung mit SQ2 und einer gezielten Abkühlung, z. B. mit einen (in det Zeichnung nicht dargestellten) Preßlufstrahl erreicht. Neben der Einstellung eines vorgegebenen Temperaturkoeffizienten ist auf diese Weise ebenfalls eine präzise Einstellung auf den Temperaturkoeffizienten Null möglich.

Es ist in diesem Zusammenhang zu betonen, daß es sich bei der Darstellung gemäß Fig. 2 lediglich um eine bevorzugte Ausführungform handelt. So ist neben der dargestellten Laserbeheizung von B eine Vielzahl anderer Techniken, z. B. Beheizung mittel eines Querstroms durch B, Beheizung durch äußere Widerstandheizungen usw., möglich und geeignet.

Die in Fig. 2 dargestellte Ausführungsform eignet sich hinsichtlich ihres Aufbaues auch für die Einstellung der Photoempfindlichkeit von Bauelementen.

Bei Einschalten der Strahlungsquelle SQ1 erhält man entsprechend einen Widerstand $R_L$ für das Bauelement unter Lichtbestrahlung, relativ zu einen Widerstand $R_0$ ohne Lichtbestrahlung. Die Differenz $R_L$ - $R_0$ läßt sich zur Einstellung einer vorbestimmten Lichtempfindlichkeit heranziehen.

Für die gezielte Einstellung des piezoresistiven Koeffizienten muß das Bauelement in zwei Zustände versetzt werden, bei denen es unterschiedlich elastisch vorgespannt ist. Die entsprechenden Widerstände sind dann $R_{d1}$ und $R_{d2}$.

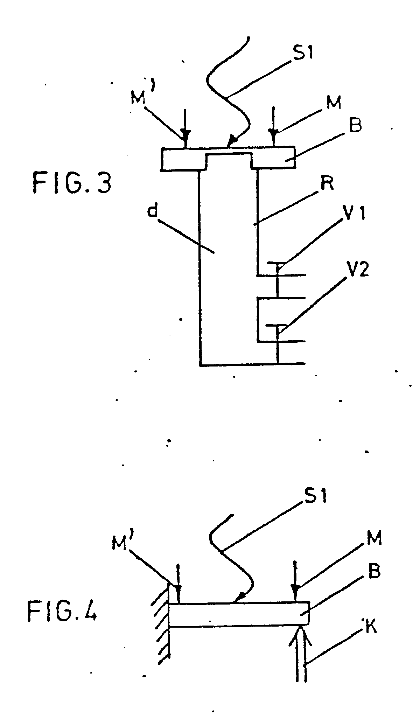

In Fig. 3 ist eine Ausführungsform für die Vorrichtung V dargestellt, wobei zur Vereinfachung die übrigen Elemente, die anhand der Fig. 1 im einzelnen erläutert wurden, weggelassen sind. Das Bauelement B bildet hier die Endabschlußwand eines Behälters, wie etwa eines Rohres R. Durch das Schließen bzw. Öffnen von an das Rohr R angeschlossenen Ventilen V1 und V2 ist der Innenraum d des Behälters R in verschiedene Druckzustände vetsetzbar. Somit sind unterschiedliche und reproduzierbar steuerbare elastische Vorspannungen des Bauelementes B möglich.

Gemäß der in Fig. 4 dargestellten Ausführungsform kann das Bauelement B auch einseitig fest eingespannt sein, während man am gegenüberliegenden freien Ende eine mechanische Kraft K einwirken läßt, die eine elastische Biegung des Bauelementes bewirkt. Die Einstellung erfolgt der obigen Beschreibung entsptechend.

## Patentansprüche

1. Verfahren zur Herstellung von Halbleiterbauelementen, insbesondere von Halbleitersensoren, bei dem das dotierte Halbleiterbauelement (B) mit einer seine Eigenschaften verändernden optischen Strahlung ($S_1$) bestrahlt, der zwischen zwei am Halbleiterbauelement angreifenden Meßspitzen (M, M') auftretende Widerstand innerhalb des Halbleiterbauelementes gemessen und das Meßergebnis zur Steuerung der Bestrahlungsintensität und -dauer benutzt wird, dadurch gekennzeichnet,
daß zur Einstellung einer vorgegebenen quantitativen Abhängigkeit des Widerstandes von einer ihn beeinflußenden physikalischen Einflußgröße (G) das Halbleiterbauelement mit den Meßspitzen in eine Einrichtung zur reproduzierbaren Einstellung vorbestimmter Werte der betreffenden Einflußgröße eingesetzt wird, zwei unterschiedliche feste Werte der Einflußgröße ($G_0$, $G_1$) eingestellt und die zwei zugehörigen Widerstandswerte ($R_0$, $R_1$) gemessen werden, und daß das Halbeiterbauelement solange wiederholt mit einer entsprechenden Intensität der optischen Strahlung bestrahlt wird, bis sich bei dem Bauelement für die zwei festen Werte der Einflußgröße zugehörige Widerstandswerte eingestellt haben, deren Differenz ($R_0$, $R_1$) einen vorgegebenen Wert aufweist.

2. Verfahren nach Anspruch 1, dadurch gekennzeichnet, daß zur Einstellung eines vorbestimmten Temperaturkoeffizienten des Widerstandes die Einflußgröße die im Halbleiterbauelement herrschende Temperatur ist, daß zur Einstellung einer vorbestimmten Lichtempfindlichkeit die Einflußgröße die auf das Halbleiterbauelement auftreffende Lichtstrahlung ist, und daß zur Einstellung des piezoresistiven Koeffizienten die Einflußgröße die elastische Vorspannung des Halbleiterbauelementes ist.

3. Verfahren nach Anspruch 2, dadurch gekennzeihnet, daß zur Erzeugung der elastischen Vorspannung das Halbleiterbauelement als Endabschlußwand eines Behälters verwendet und der Innenraum des Behälters in verschiedene Druckzustände versetzt wird.

4. Verfahren nach Anspruch 2, dadurch gekennzeichnet, daß zur Erzeugung der elastischen Vorspannung das Halbleiterbauelement einseitig fest eingespannt und an seinem gegenüberliegenden freien Ende mit einer mechanischen Kraft beaufschlagt wird.

5. Verfahren nach einem der vorangehenden Ansprüche, dadurch gekennzeichnet, daß man ein Halbleiterbauelement verwendet, das aus einer polykristallinen Halbleiterschicht besteht, die zur Erzeugung einer elektrischen Leitfähigkeit dotierbar ist.

6. Verfahren nach einem der Ansprüche 1 bis 3, dadurch gekennzeichnet, daß man ein Halbleiterbauelement verwendet, das aus einer dotierten polykristallinen Siliziumschicht besteht.

7. Verfahren nach einem der vorangehenden Ansprüche, dadurch gekennzeichnet, daß man das Halbleiterbauelement zunächst auf einem Gehäuse montiert und erst kurz vor seiner Fertigstellung auf die vorgegebene Differenz der Widerstandwerte ($R_0$-$R_1$) einstellt.

8. Vorrichtung zur Durchführung des Verfahrens nach einem der vorangehenden Ansprüche mit einer ersten Strahlungsquelle (SQ1) für die optische Strahlung, einer Einstellungseinrichtung (I) für die Strahlungsintensität, einer optischen Einstelleinrichtung (0) für den dem Halbleiterbauelement zugeführten Strahl (S1), und mit am Halbleiterbauelement (B) angreifenden Meßspitzen (M-M'), die mit einer elektrischen Steuerung (E1) für die Einstelleinrichtung (I) für die Strahlungsintensität in Verbindung steht, dadurch gekennzeichnet, daß im Bereich des Bauelementes (B) eine Einrichtung (V) zur Einstellung vorbestimmter Werte einer Einflußgröße angeordnet ist, die den zwischen den Meßspitzen innerhalb des Halbleiterbauelementes auftretenden Widerstand beeinflußt.

9. Vorrichtung nach Anspruch 8, dadurch gekennzeichnet, daß die Einrichtung (V) eine zweite Strahlungsquelle (SQ2), eine Zeitsteuerung (Z) sowie ein Spiegelsystem (SP) zur gesteuerten Beaufschlagung des Bauelementes (B) mit einer zweiten Strahlung umfaßt.

10. Vorrichtung nach Anspruch 8, dadurch gekennzeichnet, daß die Einrichtung (V) eine Biegevorrichtung für das Bauelement (B) umfaßt.

## Claims

1. Process for the manufacture of semiconductor elements, especially semiconductor sensors, by radiating the doped semiconductor element (B) with an optical radiation ($S_1$) modifying its characteristics, measuring the resistance appearing within the semiconductor element between two measuring points (M, M') attached to said semiconductor element, and using the result for controlling the intensity and duration of the radiation characterized by the fact that for the establishment of a predetermined quantitative dependence of the resistance from a physical quantity of influence (G) acting on the same, one inserts the semiconductor element with its measuring points into an installation for a reproducible setting of a predetermined value of the respective quantity of influence, one sets the two different fixed values of the quantity of influence ($G_0$, $G_1$) and measures the two corresponding resistence values ($R_0$, $R_1$), whereon the semiconductor element is repeatedly subjected to a corresponding intensity of the optical radiation until for the two fixed values of quantity of influence in the element there have been established corresponding values of resistance, the difference ($R_0$, $R_1$) of which represents a predetermined value.

2. Process according to claim 1, characterized by the fact that: for the setting of a predetermined temperature coefficient of the resistance, the quantity of influence being the temperature which is present in the semiconductor element, for the setting of a predetermined light sensitivity, the quantity of influence being the radiation impacting the semiconductor element, and for the setting of the piezo resistive coefficient the quantity of influence being the resilient prestress of the semiconductor element.

3. Process according to claim 2, characterized by the fact that for establishing the resilient prestress the semiconductor element is used as endwall of a receptacle and the interior of said receptacle is subjected to different pressure conditions.

4. Process according to claim 2, characterized by the fact that for establishing the resilient prestress, the semiconductor element is fixedly clamped at one end and the opposite free end is submitted to the action of a mechanical force.

5. Process according to one of the preceding claims, characterized by the fact that a semiconductor element is used which consists of a polycrystalline layer which is dopable for establishing an electrical conductibility.

6. Process to one of claims 1 to 3, characterized by the fact that a semiconductor element is used consisting of a doped crystalline silicium layer.

7. Process according to one of the preceding claims, characterized by the fact that the semiconductor element is first mounted to a housing and only shortly before completion there is set the predetermined difference of resistance values ($R_0$- $R_1$).

8. Apparatus for carrying out the process according to one of the preceding claims, comprising a first radiation source (SQ1) for the optical radiation, setting device (I) for the radiation intensity, an optical setting device (0) for the beam (S1) directed to the semiconductor element, and measuring points (M-M') attached to said semiconductor element (B) which are connected to an electrical controlling device (E1) for the setting device (I) for the radiation intensity, characterized by the fact that in the range of the element (B) there is provided a device (V) for setting the predetermined quantities of influence controlling the resistance appearing between the measuring points within the semiconductor element.

9. Apparatus according to claim 8, characterized by the fact that the deice (V) comprises a second radiation source (SQ2), a timer (Z) and a mirror system (SP) for a controlled subjection of the element (B) to a second radiation.

10. Apparatus according to claim 8, characterized by the fact that the device (V) comprises a handing installation for the element (B).

### Revendications

1. Procédé de réalisation de modules, notamment de capteurs, semi-conducteurs dans lequel on irradie le module semi-conducteur dopé (B) au moyen d'un rapport rayonnement optique ($S_1$) modifiant ses caractéristiques, on mesure la résistance apparaissant à l'intérieur du module semi-conducteur entre deux pointes de mesure attaquant ce dernier et l'on utilise le résultat de la mesure à la commande de l'intensité et de la durée de l'irradiation, procédé caractérisé par le fait que, pour établir une relation de dépendance quantitative prédéterminée de la résistance par rapport à une grandeur d'influence physique (G) agissant sur celle-ci, on insère le module semi-conducteur avec les pointes de mesure dans un dispositif de réglage reproductible à des valeurs prédéterminées de la grandeur d'influence considérée, on se règle à deux valeurs fixes différentes ($G_0$, $G_1$) de la grandeur d'influence et mesure les deux valeurs de résistance ($R_0$, $R_1$) correspondantes, puis l'on irradie sous une intensité correspondante du rayonnement optique le module semiconducteur de façon répétée jusqu'à ce que, pour les deux valeurs fixes de la grandeur d'influence, il se soit établi dans le module des valeurs de résistance correspondantes dont la différence ($R_0$, $R_1$) présente une valeur prédéterminée.

2. Procédé selon la revendication 1 caractérisé par le fait que: pour établir un coefficient de température predéterminé de la résistance, la grandeur d'influence est la température régnant dans le module semi-conducteur; pour établir une sensibilité lumineuse prédéterminée, la grandeur d'influence est le rayonnement lumineux heurtant le module semi-conducteur et, pour établir le coefficient piézorésistif, la grandeur d'influence est la précontrainte élastique du module semi-conducteur.

3. Procédé selon la revendication 2 caractérisé par le fait que, pour engendrer la précontrainte élastique, on utilise le module semi-conducteur en paroi terminale de fermeture d'un récipient et l'on soumet le volume intérieur dudit récipient à différents états de pression.

4. Procédé selon la revendication 2 caractérisé par le fait que, pour engendrer la précontrainte élastique, on bride à force d'un côté le module semi-conducteur et on le soumet à l'action d'une force mécanique sur son extrémité libre opposée.

5. Procédé selon l'une des revendications précédentes caractérisé par le fait que l'on utilise un module semiconducteur composé d'une couche semi-conductrice polycristalline qui est dopable pour engendrer une conductibilité électrique.

6. Procédé selon l'une des revendications 1 à 3 caractérisé par le fait que l'on utilise un élément semi-conducteur composé d'une couche de silicium polycristalline dopée.

7. Procédé selon l'une des revendications précédentes caractérisé par le fait que l'on monte tout d'abord le module semi-conducteur sur un carter et que c'est seulement peu avant son achèvement qu'on le règle à la différence prédéterminée $(R_0-R_1)$ des valeurs de résistance.

8. Dispositif de mise en oeuvre du procédé selon l'une des revendications précédentes, avec une première source (SQ1) pour le rayonnement optique, un dispositif de réglage (I) pour l'intensité de rayonnement, un dispositif de réglage optique (0) pour le rayon (S1) amené au module semi-conducteur et, attaquant ledit module semi-conducteur (B), des pointes de mesure (M-M') qui sont reliées à une commande électrique (E1) du dispositif de réglage (I) de l'intensité de rayonnement, caractérisé par le fait que dans la région du module (B) il se trouve un dispositif (V) de réglage à des valeurs prédéterminées d'une grandeur d'influence qui agit sur la résistance apparaissant entre les pointes de mesure à l'intérieur de l'élément semi-conducteur.

9. Dispositif selon la revendication 8 caractérisé par le fait que le dispositif (V) comporte une deuxième source de rayonnement (SQ2), une synchronisation (Z) ainsi qu'un système de miroirs (SP) pour soumettre sur commande le module (B) à l'action d'un deuxième rayonnement.

10. Dispositif selon la revendication 8 caractérisé par le fait que le dispositif (V) comprend un dispositif de cintrage du module (B).

FIG.1

SQ1

I

E1

O

S1

V

M)

B

M

FIG.2

FIG.3

FIG.4